# EUROPEAN PATENT APPLICATION

(11) **EP 1 398 875 A1**
(43) Date of publication of application: **17.03.2004**
(21) Application number: 03396083.2
(22) Date of filing: 10.09.2003
(51) Int. Cl.: H03G 3/30, H01Q 9/04, H01Q 5/00, H01Q 1/24

(54) **System for controlling the transmitting power of a multiband antenna**

(30) Priority: 12.09.2002 FI 20021630
(71) Applicant: Filtronic LK Oy, 90440 Kempele (FI)
(72) Inventor: Haapala, Tomi, 90440 Kampele (FI); Sallinen, Ville, 36270 Kangasala (FI); Annamaa, Petteri, 90460 Oulunsalo (FI)
(74) Representative: Kupiainen, Juhani

(57) **Abstract**

A control system for the transmitting power of a multiband antenna of especially a mobile station. The antenna (300) has at least two radiating elements (B31,B32) corresponding to different operating bands. A separate part is arranged for each element in the antenna switch of a radio device using TDD technology. When one radiating element (B31) is connected to a transmitter (TX1), the other radiating element (B32) is connected to a control circuit (DET,PCU) for a radio-frequency power amplifier (PA1) of the transmitter. By an electromagnetic coupling (CP) between the radiating elements is then produced to the control circuit a signal (M1) indicating the transmitting power, and the transmitting power can be kept as desired by controlling the power amplifier. The electromagnetic coupling between the elements is arranged suitable in view of the power control. The arrangement achieves space savings on the circuit board of the radio device as the relatively large directional couplers can be left out and the attenuation in the transmission path from the power amplifiers to the antenna will be lower.The two radiating elements can realize a dual PIFA antenna structure.

## Description

The invention relates to an arrangement for controlling the transmitting power of a multiband antenna of especially a mobile station. The invention further relates to a method for controlling the transmitting power of a multiband antenna of especially a mobile station.

It is common to set limits on the transmitting power of radio devices in order to keep the interference level in receivers low enough. Transmitting power restrictions are particularly well-grounded in mobile terminals because of the great number and density of the devices. On the other hand, the transmitting power naturally has to be high enough for getting the transmitted signal through. If the impedance of the transmitting antenna is known and stays constant, the transmitting power of a radio transmitter can be set with good accuracy by choosing suitable component values for the radio-frequency power amplifier. However, in mobile stations, for example, the immediate surroundings have an effect on the transmitting power. Dielectric material and conductive material in particular change the impedance matching of the antenna and, hence, the transmitting power. Therefore it is advantageous to measure the real transmitting power, and control the radio-frequency power amplifier so that the transmitting power stays at the set value.

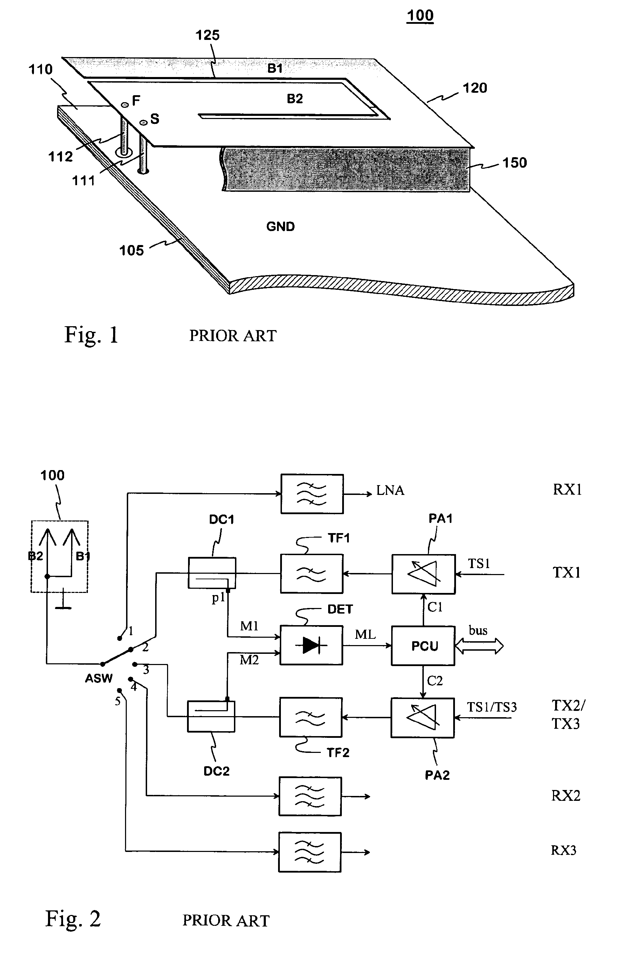

The transmitting power measurement is usually realized using a directional coupler, which is part of the antenna feedline. Figs. 1 and 2 show an example of such a known arrangement. Fig. 1 shows a known antenna, applicable in mobile stations, and Fig. 2 shows schematically the antenna end of a radio device utilizing that antenna. The antenna in this example is a dual-band antenna since the invention also applies to an arrangement in a multi-band device. The antenna 100 in Fig. 1 is a planar inverted F antenna (PIFA). It comprises a ground plane 110 on a surface of a circuit board 105 in a radio device, and a radiating plane 120 elevated from the ground plane. The radiating plane is supported by a dielectric frame 150 on the circuit board 105. The radiating plane is galvanically connected to the ground plane by a short-circuit conductor 111 at a short-circuit point S. An antenna feed conductor 112 is galvanically connected to the radiating plane through a via hole in the circuit board 105 at a feed point F. Furthermore, the radiating plane 120 has a non-conductive slot 125 starting from the edge thereof such that, viewed from the short-circuit point S, the plane is divided into two branches of different lengths: a first branch B 1 goes round along the edges of the plane and a second, shorter branch B2 lies in the middle section of the plane. The branches also have different electrical lengths so that the antenna has a lower operating band corresponding to the first branch, and an upper operating band corresponding to the second branch.

In Fig. 2 the antenna 100 can be connected by means of the antenna switch ASW to a transmitting or receiving part in the radio device. The radio device at issue thus utilizes time division duplex (TDD) technology. In this example the antenna switch has five positions. At position 1 the antenna is connected to a first receiver RX1, at position 4 to a second receiver RX2, and at position 5 to a third receiver RX3. The first receiver can be e.g. in accordance with the GSM900 system (Global System for Mobile telecommunications), the second one with the GSM1800 system, and the third one with the GSM1900 system. In this case the aforementioned upper operating band of the antenna 100 is wide enough to cover the frequency range of both the GSM1800 and GSM1900 system. The radio device includes respective three transmitters. The first transmitter TX1 comprises, along the direction of signal propagation, a first power amplifier PA1, first antenna filter TF1, and a first directional coupler DC1, connected in series. The first directional coupler is connected to the antenna when the antenna switch is at position 2. The second TX2 and third TX3 transmitters share, along the direction of signal propagation, a second power amplifier PA2, second antenna filter TF2, and a second directional coupler DC2, connected in series. The second directional coupler is connected to the antenna when the antenna switch is at position 3.

When the first transmitter TX1 is active, power amplifier PA1 receives a radio-frequence signal TS 1 which is amplified and fed to the antenna. From pole p 1 of the first directional coupler DC1 it is obtained a first radio-frequency measurement signal M1 proportional to the strength of the field propagating towards the antenna. When, for example, the matching of the antenna becomes worse for external reasons, the strength of the field reflected from the antenna increases and the strength of the propagating field decreases. The real transmitting power is proportional to the square of the strength of the propagating field, so the measurement signal M1 serves as an indicator of the transmitting power. The measurement signal is brought to a detector DET which outputs a signal ML proportional to changes in the level of said measurement signal. In a power control unit PCU, signal ML is compared with a reference level corresponding to a certain transmitting power, and, on the result basis, the first power amplifier PA1 is controlled by a control signal C1. If an external factor causes the transmitting power for example to drop, control C1 changes such that it increases the amplification in the power amplifier until the level of signal ML again equals said reference level. The reference level is set by software through a bus in the radio device. Similarly, when the second or third transmitter is active, it is obtained from the second directional coupler DC2 a second measurement signal M2 proportional to the strength of the field propagating towards the antenna, and on grounds of detection result of the signal M2 the second power amplifier PA2 is controlled by a control signal C2.

A disadvantage of the arrangement according to Fig. 2 is that the directional couplers, being relatively large components, take up an impractically large space on the circuit board. Moreover, they cause extra attenuation in the signal to be transmitted, which is particularly disadvantageous in that part of the transmitter which follows the radio-frequence power amplifier.

An object of the invention is to alleviate said disadvantages associated with the prior art. An arrangement according to the invention is characterized in that which is specified in the independent claim 1. A method according to the invention is characterized in that which is specified in the independent claim 10. Preferred embodiments of the invention are presented in the other claims.

The idea of the invention is basically as follows: An antenna has at least two radiating elements corresponding to different operating bands. For each element is given a separate part of its own in the antenna switch of a radio device using TDD technology. When a radiating element is connected to a transmitter, an other element is connected to a control circuit of the radio-frequency power amplifier of the transmitter in question. The control circuit thus gets a signal indicative of transmitting power through an electromagnetic coupling between the radiating elements, and the transmitting power can be kept at a desired level by controlling the power amplifier. The electromagnetic coupling between the elements is arranged suitable in view of the power control.

An advantage of the invention is that space is saved on the circuit board of a radio device as the relatively large directional couplers can be left out. Another advantage of the invention is that, for the reason mentioned above, attenuation decreases on the transmission paths leading from the power amplifiers to the antenna, reducing energy consumption and warming of the power amplifiers. A further advantage of the invention is that as the number of components drops, the production costs of the radio device drop, too.

The invention is now described more closely. The description to follow refers to the accompanying drawings where
- Figs. 1,2: illustrate an arrangement according to the prior art for controlling the transmitting power,
- Fig. 3: illustrates an example of the antenna according to the invention,
- Fig. 4: is a block diagram illustrating an arrangement according to the invention for controlling the transmitting power,
- Fig. 5: illustrates a second example of the antenna according to the invention,
- Fig. 6: illustrates examples of antenna tuning ways in an arrangement according to the invention, and
- Fig. 7: is a flow diagram illustrating the method according to the invention.

Figs. 1 and 2 were already discussed in conjunction with the description of the prior art.

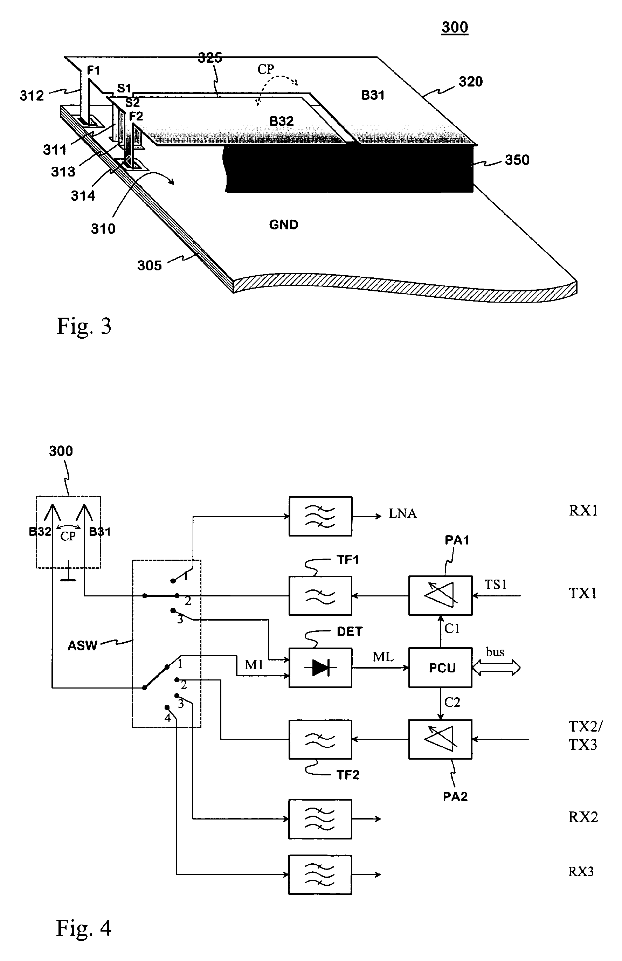

Fig. 3 shows an example of a dual-band planar antenna according to the invention corresponding to the antenna shown in Fig. 1. A substantial difference to Fig. 1 is that now the slot 325 in the radiating plane 320 of the antenna 300 both starts from an edge of the plane and ends up at an edge of the plane whereby the first B31 and second B32 radiating elements are galvanically isolated from one another. Between them there is only an electromagnetic coupling CP. Consequently, each radiating element needs a feed conductor of its own. The first radiating element B31, or the first element in short, has a first feed conductor 312 connected thereto at a feed point F1, and the second radiating element B32, or the second element in short, has a second feed conductor 314 connected thereto at a feed point F2. Similarly, each radiating element has a short-circuit conductor of its own: a first short-circuit conductor 311 connected at point S1, and a second short-circuit conductor 313 connected at point S2. In this example the feed and short-circuit conductors are of the spring contact type and they are a part of the same metal sheet as the radiating element at issue. When installed, a spring force presses them against the circuit board 305 of the radio device. The first element B31 is physically and electrically longer than the second element wherefore it is used to produce the lower operating band of the antenna.

Fig. 4 shows an example of an arrangement according to the invention for controlling transmitting power, corresponding to the arrangement of Fig. 2. In Fig. 4, the radiating elements of the antenna 300 are represented by arrow-shaped symbols pointing upwards. Between them there exists said electromagnetic coupling CP. The antenna switch ASW now comprises two separate parts: a first part having three positions, and a second part having four positions. When the first part of the antenna switch is at position 1, the first element B31 is connected to the first receiver RX1. When the second part of the antenna switch is at position 3, the second element B32 is connected to the second receiver RX2, and when it is at position 4, the second element is connected to the third receiver RX3. The radio device has three transmitters respectively. The first transmitter TX1 comprises, connected in series along the direction of signal propagation, a first power amplifier PA1 and a first antenna filter TF1. At position 2 of the first part of the antenna switch the first antenna filter is connected to the first element B31 of the antenna. This situation is depicted in Fig. 4. The second TX2 and third TX3 transmitters share, along the direction of signal propagation, a second power amplifier PA2 and a second antenna filter TF2, connected in series. At position 2 of the second part of the antenna switch the second antenna filter is connected to the second element B32 of the antenna. At position 3 of the first part of the antenna switch ASW the first element B31 is connected to the detector DET. At position 1 of the second part of the antenna switch the second element B32 is connected to the detector DET, which situation is depicted in Fig. 4.

When the first transmitter TX1 is active, power amplifier PA1 receives a radio-frequency signal TS 1 which is amplified and fed in accordance with Fig. 4 to the part of antenna corresponding to the first element B31. Due to said electromagnetic coupling CP, part of the energy fed is transferred into the circuit of the second element B32. The electromagnetic coupling is arranged to be so weak that the portion of the energy transferred is relatively small; the isolation attenuation of the elements is 15 to 20 dB, for instance. The idea is to obtain a signal of high enough level from the second element for the purpose to measure the field fed. Thus, instead of a separate directional coupler, the second antenna element B32 is used as a measurement element. The second element produces a first radio-frequency measurement signal M1 proportional to the strength of the field propagating towards the first element of the antenna. This is suitable, like measurement signal M1 in Fig. 2, for indicating the transmitting power. The measurement signal is brought to detector DET which outputs a signal ML proportional to the change of level thereof. The level of signal ML is compared in a power control unit PCU with a reference level corresponding to a certain transmitting power, and, on the result basis, the first power amplifier PA1 is controlled by a control C1. The feedback described keeps in this case, too, the level of the measurement signal ML equal to the reference level, i.e. keeps the transmitting power nominal. The reference level is set by software through a bus in the radio device. Similarly, when the second or third transmitter is active, instead of a separate directional coupler, the first antenna element B31 is used as a measurement element. In that case the second part of the antenna switch is at position 3 and the first part is also at position 3. The first element gives a second radio-frequency measurement signal proportional to the strength of the field propagating towards the second element of the antenna, and on grounds of this detection result the second power amplifier PA2 is controlled by a control signal C2.

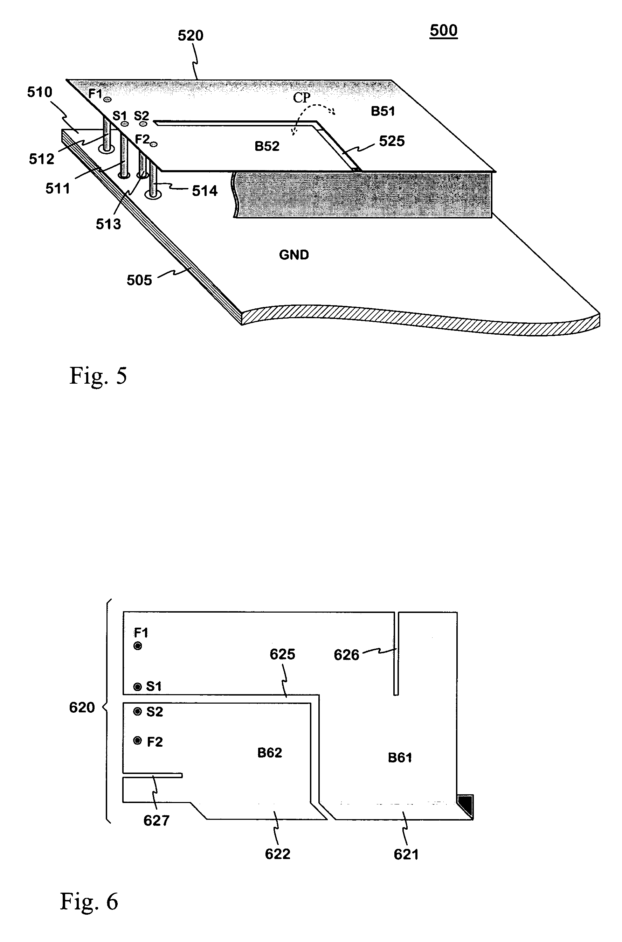

Fig. 5 shows a second example of an antenna according to the invention. The difference to Fig. 3 is that now the slot 525 in the radiating plane 520 of the antenna 500 ends up in the inner region of the plane, instead of an edge of the plane. The end point of the slot 525, or the closed end, is relatively close to that end of the radiating plane where the antenna feed arrangement is located. In the area between the closed end of the slot and said end of the plane there are the short-circuit points of the antenna, which there are two in the example of Fig. 5: a first short-circuit point S 1 to which a first short-circuit conductor 511 is connected, and a second short-circuit point S2 to which a second short-circuit conductor 513 is connected. There may also be just one short-circuit conductor. This would be e.g. a relatively wide spring contact, like the ones depicted in Fig. 3, and it would be located at the closed end of the slot 525 at the gable of the antenna. Viewed from the short-circuit area, the radiating plane is divided by the slot 525 into two branches, or radiating elements, of different lengths: The first element B51 is limited by a first long side of the plane, the end opposite to the short-circuit area, and by a portion of a second long side. The second, shorter element B52 is limited by a second portion of the second long side of the radiating plane. The first element B51 has a first feed conductor 512 connected thereto at a feed point F1, and the second element B52 has a second feed conductor 514 connected thereto at a feed point F2. Between the first and second elements there is a certain electromagnetic coupling CP. It is utilized for controlling the transmitting power of the antenna, as in the arrangement according to Figs. 3 and 4.

Compared to the prior art, antennas in the arrangements according to Figs. 3, 4 and 5 need more feed and short-circuit conductors and the antenna switch is larger. However, the exclusion of two directional couplers means that as a whole, the components of the radio device require less space and the overall manufacturing costs are smaller.

The appropriate isolation attenuation between the radiating antenna elements is set by determining the width of the slot between the elements and by element design. Arrangements for the isolation attenuation naturally have an effect on the resonance frequencies of the antenna and thus on the locations of the operating bands. Therefore, the resonance frequencies need to be tuned separately after the tuning of the isolation attenuation. Fig. 6 shows examples of ways to tune antenna resonance frequencies in an arrangement according to the invention. Fig. 6 shows a radiating plane 620 divided into a first element B61 and second element B62. These have feed points F1, F2 and short-circuit points S1, S2, respectively, of their own. The ground plane is not drawn. The electrical length and, thus, the fundamental resonance frequency of the first element B61 are determined by a first tuning slot 626 directed from an edge of the element towards the center region of the element, and by a first extension 621 located at the farther end of the element relative to the short-circuit point S1 and directed towards the ground plane. At the ground-plane-side end of the extension 621 there is further a fold parallel to the ground plane, directed into the interior of the antenna. The electrical length and, thus, the fundamental resonance frequency of the second element B62 are determined by a second tuning slot 627 directed from an edge of the element towards the center region of the element, and by a second extension 622 directed from a side of the element towards the ground plane. These arrangements make it possible to tune the resonance frequencies at gigahertz frequencies within a range of about one hundred megahertz.

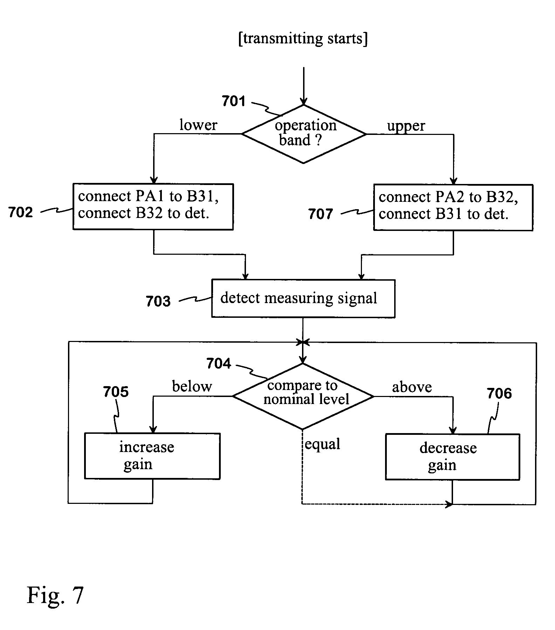

Fig. 7 illustrates in a flow diagram the method according to the invention. The flow diagram starts with the beginning of transmitting period. At step 701 it is defined which of the two operating bands of the antenna will be used for the transmitting. This depends on which of the transmitters is active, which is known by the power control unit PCU shown in Fig. 4, for example. If the first transmitter, which uses the lower operating band, is activated, the first power amplifier is connected in accordance with step 702 to the first element radiating in the lower operating band of the antenna. In addition, the second radiating element of the antenna, which is used as a measurement element in this situation, is connected to the detector used in the transmitting power control. These connections may be controlled by the aforementioned power control unit, for example. At step 703 it is detected the radio-frequency measurement signal brought to the detector, which signal depends on the transmitting power. At step 704 it is compared the level of the detected measurement signal against a reference level corresponding to nominal power. If the measured level is below the reference level, the amplification of the power amplifier currently in use is increased in accordance with step 705. If the measured level is above the reference level, the amplification of the power amplifier currently in use is decreased in accordance with step 706. The control may also have hysteresis such that when the measured level equals the reference level within a certain tolerance, the amplification will not be changed. If at step 701 it appears that the upper operating band is needed, the second power amplifier is connected in accordance with step 707 to the second element radiating in the upper operating band of the antenna. In addition, the first radiating element of the antenna, which is used as a measurement element in this situation, is connected to the detector used in the transmitting power control. The operation then continues in accordance with steps 703 to 706.

Solutions according to the invention were described above. The invention is not limited to those. The antenna elements may be other than planar elements, and the number of operating bands in the antenna may be greater than two. The structure of the antenna end of the transmitters may differ from those described. The invention does not restrict the implementation of the antenna switch, detector and power control unit. For example, control operation in the power control unit may be analog or digital, being program-based in the latter case. The inventional idea can be applied in various ways within the scope defined by the independent claims 1 and 10.

## Claims

1. An arrangement for controlling transmitting power of an antenna (300; 500) in a radio device, which antenna comprises a first radiating element to provide a lower operating band, and a second radiating element to provide an upper operating band, and which arrangement comprises
- a first power amplifier for feeding the antenna with a signal of the lower operating band,
- a second power amplifier for feeding the antenna with a signal of the upper operating band,
- an antenna switch for connecting the antenna to a transmitter or receiver part according to the phase of operation of the radio device,
- measurement elements for measuring the strength of the field propagating to the antenna both in the lower and in the upper operating band,
- a detector for converting a radio-frequency measurement result into a low-frequency signal indicating the transmitting power, and
- a power control unit (PCU) for controlling the feeding power amplifier on the basis of the signal indicating the transmitting power,
**characterized in that**
- there is an electromagnetic coupling (CP) between the first (B31; B51) and the second (B32; B52) radiating elements,
- the antenna switch (ASW) has a first part with which the first radiating element can be connected to the first power amplifier (PA1) or the detector (DET), and a second part with which the second radiating element can be connected to the second power amplifier (PA2) or the detector (DET),
- said measurement elements for measuring the transmitting power of the antenna in the lower operating band substantially comprise the second radiating element (B32), and
- said measurement elements for measuring the transmitting power of the antenna in the upper operating band substantially comprise the first radiating element (B31).

2. An arrangement according to claim 1, **characterized in that** the first (B31) and the second (B32) radiating elements are galvanically isolated from each other.

3. An arrangement according to claim 1, **characterized in that** the first and the second radiating elements are planar elements in substantially the same geometric plane, the antenna comprises a unitary ground plane (310; 510) parallel to the planar elements, and the first and the second radiating elements are short-circuited to the ground plane.

4. An arrangement according to claims 2 and 3, **characterized in that** the first (B31) and the second (B32) planar radiating elements are both separately short-circuited to the ground plane so that the antenna has a dual-PIFA structure.

5. An arrangement according to claim 3, **characterized in that** between the first (B51) and the second (B52) planar radiating elements there is, in addition to the electromagnetic coupling, a galvanic coupling, and said short-circuiting of the second radiating element to the ground plane takes place **in that** area of the plane where said galvanic coupling is.

6. An arrangement according to claim 5, **characterized in that** the first and the second radiating elements are short-circuited to the ground plane by a single short-circuit conductor.

7. An arrangement according to claim 5, **characterized in that** the first (B51) and the second (B52) planar radiating elements are connected to the ground plane at two separate short-circuit points (S1, S2) by two short-circuit conductors (511, 513).

8. An arrangement according to claim 1, **characterized in that** to control the feeding power amplifier on the basis of the signal indicating the transmitting power, said power control unit (PCU) comprises means for comparing the level of the measurement signal indicating the transmitting power against a certain reference level and for conveying a result of the comparison to the power amplifier.

9. An arrangement according to claim 8, **characterized in that** said means are programmable.

10. A method for controlling the transmitting power of an antenna in a radio device using time-division duplex technology, which antenna comprises at least two radiating elements, one for providing a lower operating band and the other for providing an upper operating band, and the radio device further comprises a power amplifier for feeding the antenna with a signal of the lower operating band and a second power amplifier for feeding the antenna with a signal of the upper operating band,
in which method
- the currently feeding power amplifier is connected to the antenna,
- the strength of the field propagating from the feeding power amplifier to the antenna is measured by a measurement element,
- the radio-frequency measurement result is detected (703) by a detector,
- the detection result obtained is compared (704) to a certain reference level,
- the feeding power amplifier is controlled (705; 706) on the basis of the result of the comparison so that the detection result is kept equal with the reference level,
**characterized in that** there is an electromagnetic coupling between said radiating elements, and in the method the feeding power amplifier is connected (702; 707) to the radiating element with frequency-band corresponding to the power amplifier at issue, or to feeding element, and an other radiating element with respect to the feeding element is connected (702; 707) to said detector, wherein
said other radiating element is used as a measurement element for the strength of the field propagating from the feeding power amplifier to the antenna, utilizing said electromagnetic coupling.
